## Europäisches Patentamt
## European Patent Office
## Office européen des brevets

(11) Numéro de publication : **0 130 646 B1**

(12) **FASCICULE DE BREVET EUROPÉEN**

(45) Date de publication du fascicule du brevet :
30.09.87

(51) Int. Cl.⁴ : **H 03 K  3/356**, G 01 R  19/00

(21) Numéro de dépôt : 84200915.1

(22) Date de dépôt : 25.06.84

(54) Comparateur synchronisé.

(30) Priorité : 29.06.83 FR 8310740

(43) Date de publication de la demande :
09.01.85 Bulletin 85/02

(45) Mention de la délivrance du brevet :
30.09.87 Bulletin 87/40

(84) Etats contractants désignés :
DE FR GB IT

(56) Documents cités :
US-A- 4 045 686
US-A- 4 121 120
US-A- 4 358 690
PATENTS ABSTRACTS OF JAPAN, volume 6, no. 21
(E-93)(899), 6 février 1982
PATENTS ABSTRACTS OF JAPAN, volume 6, no. 6 (E-
89)(884), 14 janvier 1982

(73) Titulaire : **Laboratoires d'Electronique et de Physique Appliquée L.E.P.**
**3, Avenue Descartes**
**F-94450 Limeil-Brévannes (FR)**
**FR**
**N.V. Philips' Gloeilampenfabrieken**
**Groenewoudseweg 1**
**NL-5621 BA Eindhoven (NL)**
**DE GB IT**

(72) Inventeur : **Binet, Michel Joseph Marie**
**Société Civile S.P.I.D. 209 rue de l'Université**
**F-75007 Paris (FR)**
Inventeur : **Meignant, Didier Serge**
**Société Civile S.P.I.D. 209 rue de l'Université**
**F-75007 Paris (FR)**

(74) Mandataire : **Landousy, Christian et al**
**Société Civile S.P.I.D. 209, Rue de l'Université**
**F-75007 Paris (FR)**

## Description

L'invention concerne un comparateur synchronisé muni d'un circuit d'acquisition servant à amplifier la différence entre une tension d'entrée analogique et une tension de référence analogique, circuit d'acquisition, qui est muni de deux transistors montés comme première paire différentielle et présentant chacun une borne de commande, une première borne principale et une deuxième borne principale, la différence entre la tension d'entrée et la tension de référence étant appliquée entre les bornes de commande, les premières bornes principales présentant un premier point de connexion servant à amener un courant de réglage et les deuxièmes bornes principales étant couplées chacune, par l'intermédiaire d'une charge, à une première borne d'alimentation et à une sortie, et qui est muni d'un circuit de mémorisation servant à convertir les tensions aux sorties du circuit d'acquisition en l'une des deux tensions constantes, suivant le signe de différence des tensions d'entrée du circuit d'acquisition, circuit de mémorisation qui est constitué par une bascule bistable présentant deux transistors montés comme deuxième paire différentielle, couplés en croix, et munis chacun d'une borne de commande, d'une première borne principale et d'une deuxième borne principale, les bornes de commande étant accouplées aux sorties du circuit d'acquisition, les premières bornes principales présentant un deuxième point de connexion commun pour amener un courant de réglage et les deuxièmes bornes principales étant couplées en croix aux deuxièmes bornes principales des transistors du circuit d'acquisition.

Un tel circuit peut être appliqué entre autres à un convertisseur analogique-numérique dit parallèle dans lequel le signal d'entrée analogique est amené aux entrées de plusieurs circuits comparateurs parallèles pour obtenir un signal de sortie numérique, circuits dans lesquels cette tension d'entrée est comparée avec une tension de référence qui est différente pour chaque circuit comparateur. Les signaux de sortie des circuits comparateurs sont convertis en un signal de sortie numérique à l'aide d'un dispositif de décodage. Le comparateur synchronisé utilisé dans de tels comparateurs analogiques parallèles présente en général une structure comme décrite dans le préambule. Un tel circuit est connu entre autres du brevet des Etats-Unis d'Amérique N° 4 121 120. Dans ce circuit connu, qui est formé à l'aide de transistors bipolaires, le point de connexion d'émetteur commun de la paire différentielle du circuit d'acquisition ainsi que le point de connexion d'émetteur commun de la paire différentielle du circuit de mémorisation sont couplés à un collecteur d'une autre paire différentielle et une source de courant est insérée dans le circuit d'émetteur commun de l'autre paire différentielle. Des signaux d'horloge amenés aux entrées de cette autre paire différentielle permettent d'envoyer le courant de la source de courant, soit vers le circuit d'acquisition, soit vers le circuit de mémorisation. Les paires différentielles du circuit d'acquisition et du circuit de mémorisation sont donc commandées par des signaux d'horloge complémentaires.

Pour obtenir un bon effet du circuit connu, il est nécessaire que les deux signaux d'horloge présentent relativement un déphasage tel que la première paire différentielle arrête son fonctionnement exactement au moment où la deuxième paire différentielle est mise en circuit. Toutefois, en pratique, cette condition est difficile à satisfaire, de sorte que le circuit risque de présenter facilement des instabilités. De plus, les divers composants nécessaires pour l'autre montage différentiel augmentent rapidement la dissipation et la surface d'intégration, ce qui est indésirable surtout dans le cas de convertisseurs analogiques-numériques dans lesquels est utilisé un grand nombre de circuits comparateurs.

Ainsi, l'invention vise à fournir un comparateur synchronisé dans lequel la présence de telles instabilités est évitée. De plus, l'invention vise à fournir un tel circuit présentant une faible dissipation. Selon la présente invention, un circuit du genre mentionné dans le préambule est caractérisé en ce que le premier point de connexion commun de la première paire différentielle est couplé, par une source de courant fonctionnant de façon continue, à un point de potentiel fixe, en ce que le deuxième point de connexion commun de la deuxième paire différentielle est couplé au point de potentiel fixe par l'intermédiaire d'une source de courant mise en fonctionnement par un signal d'horloge et en ce que les bornes de commande de la deuxième paire différentielle sont couplées aux sorties du comparateur.

Ainsi, conformément à l'invention, du fait que le circuit d'acquisition fonctionne de façon continue, un signal d'horloge n'est nécessaire que pour le circuit de mémorisation, de sorte que la présence d'instabilités par rapport à des signaux d'horloge chevauchants est évitée. Du fait que le circuit présente en outre un nombre réduit de composants, sa dissipation est faible.

Une forme de réalisation d'un circuit comparateur conforme à l'invention est caractérisée en ce que la charge de chacun des transistors de la paire différentielle du circuit d'acquisition est formée par un transistor de charge présentant une borne de commande, une première borne principale et une deuxième borne principale, la borne de commande étant connectée à la première borne principale, qui est couplée à la deuxième borne principale du transistor correspondant de la paire différentielle du circuit d'acquisition et la deuxième borne principale étant couplée à la première borne d'alimentation.

L'utilisation de telles charges actives permet d'obtenir, par comparaison avec des charges résistives, comme dans le circuit connu, une plus grande amplification et, de ce fait, un fonctionnement plus rapide du circuit.

Une autre forme de réalisation d'un circuit comparateur conforme à l'invention est caractérisée en ce que chaque charge comporte en outre un circuit de décalage de niveau, qui est formé par un transistor présentant une borne de commande, une première borne principale et une deuxième borne principale, la borne de commande étant couplée à la borne de commande du transistor de charge, la deuxième borne principale étant couplée à la première borne d'alimentation et la première borne principale étant couplée, par l'intermédiaire du montage en série de plusieurs diodes de décalage de niveau, à la sortie et à une source de courant. Cette source de courant peut être caractérisée en détail du fait qu'elle est constituée par un transistor présentant une borne de commande, une première borne principale et une deuxième borne principale, la borne de commande et la première borne principale étant connectées à une deuxième borne d'alimentation. Le circuit de décalage de niveau permet de coupler les sorties des circuits comparateurs de façon directe aux entrées logiques du dispositif de décodage par exemple.

Un circuit comparateur conforme à l'invention peut être réalisé à l'aide de transistors à effet de champ du genre Schottky et notamment à l'aide de tels transistors du genre à désertion de charge. Le comparateur conforme à l'invention convient notamment à être intégré de façon monolithique sur un substrat en arséniure de gallium.

Enfin, le convertisseur analogique numérique conforme à l'invention est caractérisé en ce qu'il est muni de $2^n$ comparateurs analogiques montés en parallèle pour obtenir un signal de sortie numérique à n bits, le signal d'entrée analogique à convertir étant amené à une entrée de chaque comparateur et une tension de référence différente étant appliquée à l'autre entrée de chaque comparateur, les sorties des comparateurs étant connectées à un dispositif de codage délivrant le signal de sortie numérique à n bits à la sortie.

La description ci-après, en se référant aux dessins annexés, le tout donné à titre d'exemple non limitatif, fera bien comprendre comment l'invention peut être réalisée.

La figure 1 montre un convertisseur analogique-numérique du genre à conversion parallèle dans un schéma synoptique fonctionnel et

la figure 2 montre un comparateur analogique conforme à l'invention en technologie MESFET.

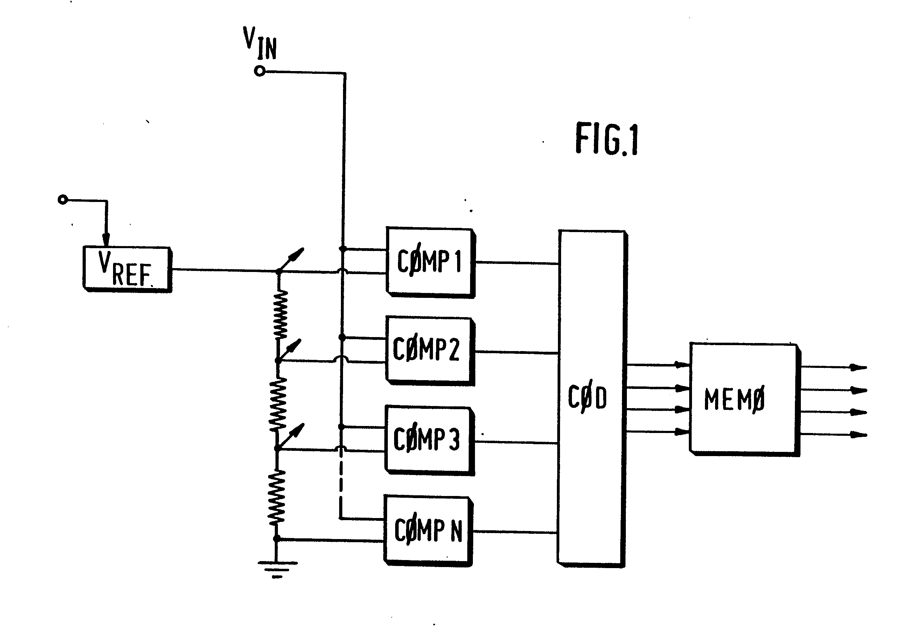

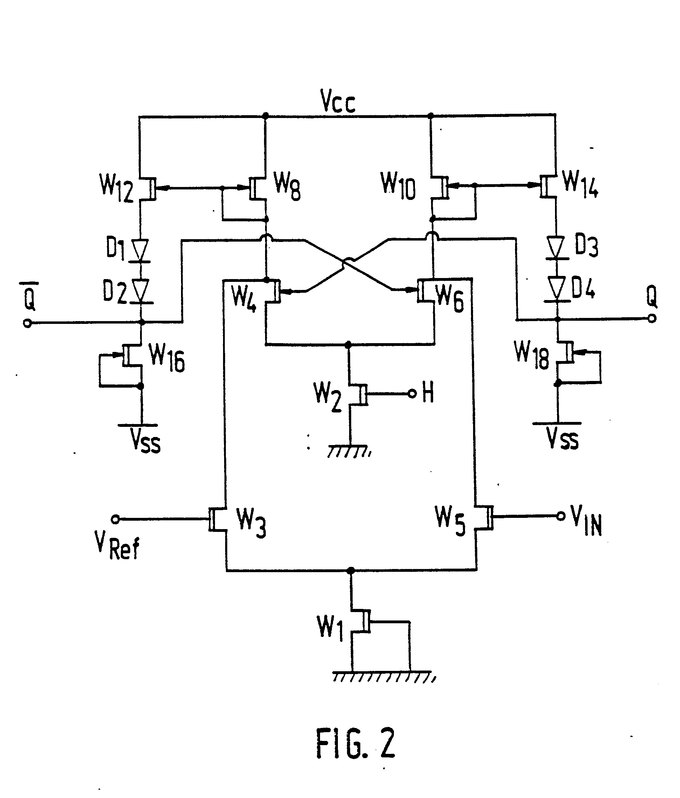

Le convertisseur analogique-numérique représenté sur la figure 1 comporte plusieurs comparateurs montés en parallèle (COMP 1, ... COMPN), qui sont munis chacun de deux entrées. La tension d'entrée analogique $V_{IN}$ à convertir est amenée à une entrée de chaque comparateur. A l'autre entrée de chaque comparateur est amenée une tension de référence obtenue par application d'une tension de référence aux bornes du montage en série de plusieurs résistances. Dans le cas où toutes les résistances sont égales, on obtient une progression géométrique des tensions de référence, le rapport relatif des tensions de référence étant égal à $V_{ref}/2$. Les diverses tensions de référence présentant un numéro de rang 1, 2, ... i, ... $2^{n-1}$, $2^n$ constituent alors une série suivante $V_{ref}/2^n$, $V_{ref}/2^{n-1}$, ... $V_{ref}$, ces dernières tensions n'étant utilisées que pour indiquer un bit de dépassement. Les sorties des comparateurs sont connectées aux entrées d'un dispositif de codage logique (COD), qui délivre un signal numérique de n bits à la sortie suivant un code quelconque, qui peut être par exemple le code de Gray. La structure du dispositif de codage est tributaire du code requis, mais n'est pas ici décrite en détail, du fait que ce dispositif de codage ne fait pas, à proprement dit, partie de l'invention. Une mémoire (MEMO) peut être couplée à la sortie du dispositif de codage pour conserver l'information du dispositif de codage pendant au moins une partie de la période d'horloge permettant la synchronisation des comparateurs. Le signal d'horloge nécessaire pour le comparateur et les mémoires est délivré par un circuit externe. Ces circuits peuvent être intégrés sur le même substrat semiconducteur. La figure 2 représente un schéma d'un comparateur analogique conforme à l'invention en technologie MESFET (Metal Semiconducteur Field Effect Transistor), qui peut être utilisé dans le convertisseur numérique-analogique de la figure précédente. Un tel comparateur comporte un circuit d'acquisition sous forme d'un amplificateur différentiel, qui est constitué par deux transistors MESFET $W_3$ et $W_5$ aux grilles desquels sont appliqués respectivement le signal de référence analogique $V_{ref}$ et le signal de comparaison $V_{IN}$. Les sources des transistors $W_3$ et $W_5$ sont connectées au drain d'un transistor $W_1$, qui est monté comme transistor de source de courant du fait que l'électrode de commande et la source sont mises à la masse. Le transistor de source de courant $W_1$ fonctionne ainsi de façon continue. La charge des transistors $W_3$ et $W_5$ est constituée par deux transistors $W_8$ et $W_{10}$, dont la source et l'électrode de commande sont court-circuitées et dont les drains sont connectés à la borne de tension d'alimentation positive $V_{CC}$. Du fait que les transistors utilisés dans ce circuit sont du genre à désertion de charge, c'est-à-dire des transistors admettant une tension de seuil $V_T < 0$, le signal de sortie du comparateur ne convient pas à priori à être amené à un circuit logique. Pour obtenir le niveau de tension requis, il est nécessaire d'utiliser un circuit de décalage de niveau. Un tel circuit de décalage de niveau est appelé logique BFL (Buffered Fet Logic). Il est constitué par un premier transistor suiveur, qui est monté en drain commun et dont l'électrode de commande est connectée à la sortie du comparateur. L'électrode de source de ce transistor suiveur est connectée, suivant le décalage de niveau requis, par l'intermédiaire de 1 à 3 diode(s) au drain d'un transistor monté comme source de courant. Le drain de ce transistor de source de courant constitue la sortie du circuit. Les drains des transistors $W_3$ et $W_5$ sont donc connectés,

par l'intermédiaire des électrodes de commande et de source court-circuitées des transistors $W_8$ et $W_{10}$, à l'électrode de commande du transistor suiveur d'un circuit de décalage de niveau. Ce circuit de décalage de niveau pour le transistor $W_3$ est formé par le transistor suiveur $W_{12}$, deux diodes $D_1$ et $D_2$ et le transistor monté comme source de courant $W_{16}$ et pour le transistor $W_5$ par le transistor suiveur $W_{14}$, les diodes $D_3$ et $D_4$ et le transistor monté comme source de courant $W_{18}$. Le signal de sortie Q et le signal de sortie complémentaire $\bar{Q}$ du comparateur se trouvent donc respectivement au drain du transistor $W_{16}$ et au drain du transistor $W_{18}$ de ces circuits de décalage de niveau. Le comparateur comporte en outre un circuit de mémorisation sous forme d'une bascule bistable qui est constituée par deux transistors $W_4$ et $W_6$ montés comme paire différentielle, dont les sources sont connectées au drain d'un transistor $W_2$, qui est monté en source commune et qui est commandé par le signal d'horloge H amené à l'électrode de commande. Les électrodes de commande des transistors $W_4$ et $W_6$ sont connectées respectivement aux sorties Q et $\bar{Q}$ du comparateur, alors que leurs drains sont couplés aux drains des transistors $W_3$ et $W_5$ du circuit d'acquisition.

Pendant un premier état de l'horloge où H = 0, état qui est appelé état de prépositionnement, les transistors $W_3$ et $W_5$ du circuit d'acquisition fonctionnent de façon continue comme amplificateurs. Ces transistors reçoivent respectivement la tension de référence analogique $V_{ref}$ et la tension analogique $V_{IN}$ à comparer et délivrent à la sortie du circuit de décalage de niveau, c'est-à-dire aux drains des transistors $W_{16}$ et $W_{18}$, les tensions $A \times V_{ref}$ et $A \times V_{IN}$, A étant le coefficient d'amplification. Pendant ce premier état, la bascule ne fonctionne pas, le transistor $W_2$ étant bloqué par le niveau H = 0.

Pendant le second état de l'horloge où H = 1, état qui est appelé état de mémorisation, le signal appliqué à l'électrode de commande du transistor $W_2$ est H = 1, de sorte que le transistor $W_2$ fonctionne comme source de courant et les transistors $W_4$ et $W_6$ fonctionnent comme bascule bistable.

La différence entre $\bar{Q}$ et Q, qui est égale à

$$A(V_{ref} - V_{IN}),$$

lors du prépositionnement, devient, après le début du deuxième état de l'horloge

$$A(V_{IN} - V_{ref}) \exp^{t/\tau},$$

jusqu'à ce qu'il se produise la saturation du signal de sortie, c'est-à-dire jusqu'à ce qu'il se produise un état stable Q = 1 ou Q = 0 suivant le signe de la différence entre les deux tensions à comparer $V_{ref}$ et $V_{IN}$. Dans l'exponentielle, t signifie le temps écoulé depuis l'apparition du second état d'horloge (H = 1) et $\tau$ le délai de propagation du signal à travers les transistors $W_2$ et $W_4$ ou $W_2$ et $W_6$. Dans un exemple réalisé par la Demanderesse, des tensions de sortie adaptées à la commande des portes logiques suivantes étaient de 0 V pour le niveau haut et de — 2 V pour le niveau bas.

Les tensions d'alimentation continues étaient

$$V_{CC} = + 4\,V$$

$$V_{SS} = — 3\,V.$$

Les transistors utilisés étaient des transistors à effet de champ, du genre auto-conducteur (« normally on ») présentant les propriétés suivantes :

$$\text{tension de seuil } (V_T = — 2\,V),$$

et les diodes du circuit de décalage de niveau étaient du genre suivant

$$\text{diode Schottky, largeur W = 12 } \mu m$$

Selon la réalisation de l'invention, les largeurs de grille (ou largeur de la diode) des transistors, comme représentées sur la figure 2 étaient les suivantes :

$$W_3 = W_5 = W_4 = W_6 = 15 \ \mu m$$

$$W_1 = 15 \ \mu m, W_2 = 30 \ \mu m$$

$$W_8 = W_{10} = 10 \ \mu m$$

$$W_{12} = W_{16} = W_{14} = W_{18} = 12 \ \mu m$$

Avec 12 transistors et 4 diodes par comparateur, la consommation est de l'ordre de 60 mW par comparateur, avec une logique du genre BFL, et de 1,5 W pour un convertisseur à 4 bits (16 niveaux).

L'utilisation d'un comparateur identique pour la réalisation d'un convertisseur analogique-numérique signifie également un avantage pour la réalisation sous forme d'un circuit intégré.

**Revendications**

1. Comparateur synchronisé muni d'un circuit d'acquisition servant à amplifier la différence entre une tension d'entrée analogique ($V_{in}$) et une tension de référence analogique ($V_{ref}$), circuit d'acquisition qui est muni de deux transistors ($W_3$, $W_5$) montés comme première paire différentielle et présentant chacun une borne de commande, une première borne principale et une deuxième borne principale, la différence entre la tension d'entrée et la tension de référence étant appliquée entre les bornes de commande, les premières bornes principales présentant un premier point de connexion servant à amener un courant de réglage et les deuxièmes bornes principales étant couplées chacune, par l'intermédiaire d'une charge ($W_8$, $W_{10}$) à une première borne d'alimentation, et muni d'un circuit de mémorisation servant à convertir les tensions aux sorties du circuit d'acquisition en l'une des deux tensions constantes, suivant le signe de différence de tensions d'entrée du circuit d'acquisition, circuit de mémorisation qui est constitué par une bascule bistable présentant deux transistors ($W_4$, $W_6$) montés comme deuxième paire différentielle, couplés en croix, et munis chacun d'une borne de commande, d'une première borne principale et d'une deuxième borne principale, les premières bornes principales présentant un deuxième point de connexion commun pour amener un courant de réglage et les deuxièmes bornes principales étant couplées aux deuxièmes bornes principales des transistors du circuit d'acquisition, caractérisé en ce que le premier point de connexion commun de la première paire différentielle est couplé par une source de courant fonctionnant de façon continue à un point de potentiel fixe, en ce que le deuxième point de connexion commun de la deuxième paire différentielle est couplé au point de potentiel fixe par l'intermédiaire d'une source de courant mise en fonctionnement par un signal d'horloge (H) et en ce que les bornes de commande de la deuxième paire différentielle sont couplées aux sorties (Q, $\bar{Q}$) du comparateur.

2. Comparateur selon la revendication 1, caractérisé en ce que les deuxièmes bornes principales de la paire différentielle du circuit de mémorisation sont couplées aux sorties du comparateur par l'intermédiaire de circuits de décalage de niveau.

3. Comparateur selon la revendication 2, caractérisé en ce que la charge de chacun des transistors de la paire différentielle du circuit d'acquisition est formée par un transistor de charge ($W_8$, $W_{10}$) présentant une borne de commande, une première borne principale et une deuxième borne principale, la borne de commande étant connectée à la première borne principale, qui est couplée à la deuxième borne principale du transistor correspondant de la paire différentielle du circuit d'acquisition et à la deuxième borne principale du transistor correspondant de la paire différentielle du circuit de mémorisation.

4. Comparateur selon la revendication 3, caractérisé en ce que chaque circuit de décalage de niveau, est formé par un transistor ($W_{12}$, $W_{14}$) présentant une borne de commande, une première borne principale et une deuxième borne principale, la borne de commande étant couplée à la borne de commande du transistor de charge, la deuxième borne principale étant couplée, par l'intermédiaire du montage en série de plusieurs diodes ($D_1$, $D_2$ ; $D_3$, $D_4$) de décalage de niveau à la sortie du comparateur et à une source de courant ($W_{16}$, $W_{18}$).

5. Comparateur selon la revendication 4, caractérisé en ce que la source de courant du circuit de décalage de niveau est constituée par un transistor présentant une borne de commande, une première borne principale et une deuxième borne principale, la borne de commande et la première borne principale étant connectées à une deuxième borne d'alimentation.

6. Comparateur selon l'une des revendications précédentes, caractérisé en ce que les transistors du circuit sont des transistors à effet de champ du genre Schottky et notamment de tels transistors du genre à désertion de charge.

7. Convertisseur analogique-numérique, caractérisé en ce que pour obtenir un signal de sortie numérique à n bits, le convertisseur analogique-numérique est muni de $2^n$ comparateurs synchronisés montés en parallèle selon l'une des revendications précédentes, et en ce que à une entrée de chaque comparateur est amené le signal d'entrée analogique à convertir et à l'autre entrée de chaque comparateur une tension de référence différente, les sorties des comparateurs étant connectées à un dispositif de codage, dont la sortie délivre le signal de sortie numérique à n bits.

**Claims**

1. A clocked comparator comprising an acquisition circuit for amplifying the difference between an analog input voltage ($V_{in}$) and an analog reference voltage ($V_{REF}$), which acquisition circuit comprises two transistors ($W_3$, $W_5$) which are arranged as a first differential pair and which each comprise a control electrode, a first main electrode and a second main electrode, the difference between the input voltage and the reference voltage being applied between the control electrodes, which first main electrodes have a common first terminal for applying a bias current and which second main electrode are each coupled to a first power-supply terminal via a load ($W_8$, $W_{10}$) and a latching circuit for converting the voltages on the outputs of the acquisition circuit into one of two constant voltages depending on the sign of the difference between the input voltages of the acquisition circuit, which latching circuit comprises a bistable latch comprising two transistors ($W_4$, $W_6$) which are arranged as a cross-coupled second differential pair and which each comprise a control electrode, a first main electrode and a second main electrode, which first main electrodes have a common second terminal for applying a bias current and which second main electrodes are coupled to the second main electrodes of the transistors of the acquisition circuit, characterized in that the common first terminal of the first differential pair is coupled to a point of fixed potential by means of a continuously operating current source, in that the common second terminal of the second differential pair is coupled to the point of fixed potential by a current source which is turned on by means of a clock signal (H), and in that the control electrodes of the second differential pair are coupled to the outputs (Q, $\bar{Q}$) of the comparator.

2. A comparator as claimed in Claim 1, characterized in that the second main electrodes of the differential pair of the latching circuit are coupled to the outputs of the comparator via level-shifting circuits.

3. A comparator as claimed in Claim 2, characterized in that the load of each of the transistors of the differential pair of the acquisition circuit is constituted by a load transistor ($W_8$, $W_{10}$) having a control electrode, a first main electrode and a second main electrode, the control electrode being connected to the first main electrode which is coupled to the second main electrode of the corresponding transistor of the differential pair of the acquisition circuit and to the second main electrode of the corresponding transistor of the differential pair of the latching circuit.

4. A comparator as claimed in Claim 3, characterized in that each level-shifting circuit comprises a transistor ($W_{12}$, $W_{14}$) having a control electrode, a first main electrode and a second main electrode, the control electrode being coupled to the control electrode of the load transistor, the second main electrode being coupled to the first power-supply terminal and the first main electrode being coupled to the output of the comparator and to a current source ($W_{16}$, $W_{18}$) by the series arrangement of a plurality of level-shifting diodes ($D_1$, $D_2$ ; $D_3$, $D_4$).

5. A comparator as claimed in Claim 4, characterized in that the current source of the level-shifting current comprises a transistor having a control electrode, a first main electrode and a second main electrode, which control electrode and first main electrode are connected to a second power-supply terminal. ·

6. A comparator as claimed in any one of the preceding Claims, characterized in that the transistors of the arrangement are Schottky field-effect transistors, in particular of the depletion type.

7. An analog-to-digital converter, characterized in that for obtaining an n-bit digital output signal the analog-to-digital converter is provided which $2^n$ parallel-connected clocked comparators and in that as claimed in any one of the preceding Claims, the analog input signal to be converted is applied to one input of each comparator and a different reference voltage is applied to the other input of each comparator the outputs of the comparators being connected to an encoding device on whose output the n-bit digital output signal appears.

**Patentansprüche**

1. Synchronisierter Komparator mit einer Erfassungsschaltung zum Verstärken des Unterschieds zwischen einer analogen Eingangsspannung ($V_{in}$) und einer analogen Referenzspannung ($V_{ref}$), wobei diese Erfassungsschaltung zwei Transistoren ($W_3$, $W_5$), die als erstes differentielles Paar geschaltet sind und je einen Steueranschluss, einen ersten Hauptanschluss und einen zweiten Hauptanschluss aufweisen, wobei der Unterschied zwischen der Eingangsspannung und der Referenzspannung zwischen den Steueranschlüssen angelegt wird, wobei die ersten Hauptanschlüsse einen ersten Verbindungspunkt zum Zuführen eines Regelstroms und die zweiten Hauptanschlüsse mittels einer Belastung ($W_8$, $W_{10}$) an je einen ersten Speiseanschluss angeschlossen sind, und eine Speicherschaltung zum Umsetzen der Ausgangsspannungen der Erfassungsschaltung in eine der beiden konstanten Spannungen entsprechend dem Unterschiedszeichen der eingangsspannungen der Erfassungsschaltung enthält, wobei die Speicherschaltung aus einem bistabilen Multivibrator mit zwei als zweiter kreuzweise geschaltetes differentieller Paar angeordneten Transistoren ($W_4$, $W_6$) besteht, die mit je einem Steueranschluss, einem ersten Hauptanschluss und einem zweiten Hauptanschluss versehen sind, wobei die ersten Hauptanschlüsse einen gemeinsamen zweiten Verbindungspunkt zum Zuführen eines Regelstroms aufweisen und die zweiten Hauptanschlüsse an die zweite Hauptanschlüsse der Transistoren der Erfassungsschaltung angeschlossen sind, dadurch gekennzeichnet, dass der erste gemeinsame Verbindungspunkt des ersten differentiellen Paares über eine kontinuierlich arbeitende Stromquelle an einen festen Potentialpunkt angeschlossen ist, dass der zweite gemeinsame Verbindungspunkt des zweiten differentiellen Paares an den festen Potentialpunkt mit Hilfe einer von einem Taktsignal (H) aktivierten Stromquelle angeschlossen ist, und dass die Steueranschlüsse des zweiten differentiellen Paares an die Ausgänge (Q, Q̄) des Komparators angeschlossen sind.

2. Komparator nach Anspruch 1, dadurch gekennzeichnet, dass die zweiten Hauptanschlüsse des differentiellen Paares der Speicherschaltung an die Ausgänge des Komparators mittels Pegelverschiebungsschaltungen angeschlossen sind.

3. Komparator nach Anspruch 2, dadurch gekennzeichnet, dass die Belastung jedes Transistors des differentiellen Paares der Erfassungsschaltung durch einen Belastungstransistors ($W_8$, $W_{10}$) mit einem Steueranschluss, einem ersten Hauptanschluss gebildet wird, wobei der Steueranschluss mit dem ersten Hauptanschluss verbunden ist, der mit dem zweiten Hauptanschluss des entsprechenden Transistors des differentiellen Paares der Erfassungsschaltung und mit dem zweiten Hauptanschluss des entsprechenden Transistors des differentiellen Paares der Speicherschaltung angeschlossen ist.

4. Komparator nach Anspruch 3, dadurch gekennzeichnet, dass jede Pegelverschiebungsschaltung aus einem Transistor ($W_{12}$, $W_{14}$) mit einem Steueranschluss, einem ersten Hauptanschluss und einem zweiten Hauptanschluss besteht wobei der Steueranschluss mit dem Steueranschluss des Belastungstransistors und der zweite Hauptanschluss über die Serienschaltung aus mehreren Pegelverschiebungsdioden ($D_1$, $D_2$, $D_3$, $D_4$) an den Komparatorausgang und an eine Stromquelle ($W_{16}$, $W_{13}$) angeschlossen ist.

5. Komparator nach Anspruch 4, dadurch gekennzeichnet, dass die Stromquelle der Pegelverschiebungsschaltung einen Transistor mit einem Steueranschluss, einem ersten Hauptanschluss und einem zweiten Hauptanschluss besteht, wobei der Steueranschluss und der erste Hauptanschluss mit einem zweiten Speiseanschluss verbunden sind.

6. Komparator nach einem der vorangehenden Ansprüche, dadurch gekennzeichnet, dass die Transistoren der Schaltung Feldeffekttransistoren vom Typ Schottky und insbesondere Transistoren vom Verarmungstyp sind.

7. Analog/Digital-Wandler, dadurch gekennzeichnet, dass zum Erhalten eines digitalen Ausgangssignals von n Bits der Analog/Digital-Wandler mit $2^n$ synchronisierten Komparatoren ausgerüstet ist, die entsprechend einem der vorangehenden Ansprüche parallelgeschaltet sind, und dass einem Eingang jedes Komparators das zu wandelnde analoge Eingangssignal und dem anderen Eingang jedes Komparators eine abweichende Referenzspannung angelegt werde, wobei die Ausgänge der Komparatoren an einen Coder angeschlossen sind, dessen Ausgang das digitale Ausgangssignal von n Bits liefert.

FIG.1

0 130 646

FIG. 2